# FASCICULE DE BREVET EUROPEEN

(11) **EP 1 764 804 B1**
(45) Date de publication et mention de la délivrance du brevet: **13.02.2008**
(21) Numéro de dépôt: 06017866.2
(22) Date de dépôt: 28.08.2006
(51) Int. Cl.: G11C 16/22

(54) **Circuit integré ayant une mémoire de données protegée contre l'effacement UV**
Integrierte Schaltung mit einem UV-löschgeschützten Speicher.
Integrated circuit comprising a UV erasure protected memory

(30) Priorité: 02.09.2005 FR 0508983
(43) Date de publication de la demande: 21.03.2007
(73) Titulaire: STMICROELECTRONICS SA, 92120 Montrouge (FR)
(72) Inventeur: Naura, David, 13100 Aix en Provence (FR); Kari, Ahmed, 13100 Aix en Provence (FR); Moreaux, Christophe, 13109 Simiane (FR); Rizzo, Pierre Résidence Port Royal, 13100 Aix en Provence (FR)
(74) Mandataire: Marchand, André

(56) Documents cités:
- EP-A- 0 874 369
- EP-A- 1 006 532
- US-A- 5 198 997

## Description

La présente invention concerne un circuit intégré comprenant une mémoire de données programmable électriquement et des moyens d'exécution de commandes de lecture ou d'écriture de la mémoire.

La présente invention concerne notamment les circuits intégrés recevant des données de transaction, notamment les circuits intégrés pour carte à puce de type porte-monnaie électronique, carte téléphonique, carte de transport, etc..

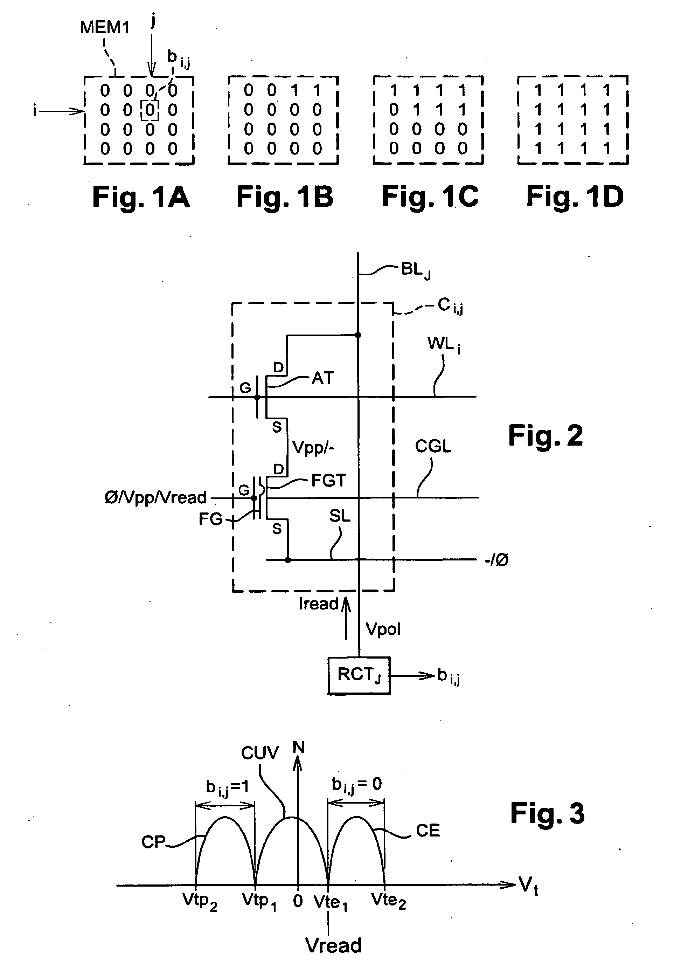

De telles données de transaction ayant une valeur monétaire et formant des sortes de "jetons" utilisables, elles sont souvent la cible des fraudeurs qui tentent de les régénérer après qu'elles ont été utilisées. Les figures 1A à 1D illustrent schématiquement un exemple d'utilisation d'une mémoire non volatile de type effaçable et programmable électriquement MEM1 pour former un compteur de données de transaction, ici un compteur de type boulier. Initialement, le compteur comprend une matrice de bits bi,j ayant chacun une valeur initiale, par exemple quatre rangées de quatre bits égaux à 0, chaque bit bi,j appartenant à une rangée horizontale i et une rangée verticale de rang j et représentant une unité de transaction. Chaque fois qu'une unité est utilisée, un bit est mis à 1 de façon irréversible en commençant par exemple par le premier bit à droite de la rangée supérieure puis en passant d'une rangée à l'autre quand les unités d'une rangée ont été utilisées. La figure 1B représente l'aspect du compteur après que 2 unités ont été utilisées, la figure 1C l'aspect du compteur après que 7 unités ont été utilisées et la figure 1D l'aspect du compteur une fois que toutes les unités ont été utilisées.

Chaque bit bi,j est stocké par une cellule mémoire et le passage de la valeur initiale du bit à la valeur "utilisée", soit ici de 0 à 1, est obtenu en faisant passer la cellule mémoire d'un état initial effacé à un état programmé. Ainsi, un fraudeur souhaitant régénérer la valeur du compteur d'unités tentera d'effacer les cellules mémoire se trouvant dans l'état programmé pour que toutes les unités du compteur soient remises à 0. A cet effet, la technique d'effacement la plus couramment utilisée est l'effacement collectif des cellules mémoire, en exposant la mémoire MEM1 à un faisceau de particules, généralement un faisceau UV (faisceau de lumière ultraviolette). Un tel faisceau UV a pour effet d'extraire des charges électriques des cellules mémoire et de les placer dans un état électrique appelé "état UV".

Ceci sera mieux compris en se référant à la figure 2 qui représente un exemple de cellule mémoire Ci,j effaçable et programmable électriquement permettant de stocker un bit bi,j. La cellule mémoire Ci,j comprend un transistor à grille flottante FGT et un transistor d'accès AT, tous deux de type NMOS. Le transistor d'accès a une borne de drain D connectée à une ligne de bit BLj, une grille G connectée à une ligne de mot WLi et une borne de source S connectée à une borne de drain D du transistor FGT. Ce dernier comporte en outre une grille flottante FG, une grille de contrôle CG reliée à une ligne de contrôle de grille CGL, et une borne de source S reliée à une ligne de source SLi.

La cellule mémoire Ci,j est mise dans l'état programmé en appliquant par exemple une tension Vpp sur la borne de drain D du transistor FGT, via le transistor d'accès AT, et une tension de plus faible valeur, par exemple 0V, sur sa grille de contrôle CG. Des charges électriques sont injectées dans la grille flottante FG et font baisser la tension de seuil Vt du transistor FGT, qui devient généralement négative. La cellule mémoire Ci,j est mise dans l'état effacé en appliquant par exemple la tension Vpp sur la grille de contrôle CG du transistor FGT et une tension de plus faible valeur, par exemple 0V, sur sa borne de source S. Des charges électriques sont extraites de la grille flottante FG et la tension de seuil du transistor FGT augmente pour devenir généralement positive.

La lecture de la cellule mémoire Ci,j est assurée par un circuit de lecture RCTj relié à la borne de drain D du transistor FGT via la ligne de bit BLj et le transistor d'accès AT. Le circuit RCTj applique à la ligne de bit une tension de polarisation Vpol pendant qu'une tension de lecture Vread est appliquée sur la grille de contrôle CG du transistor FGT. Si le transistor FGT est dans l'état programmé, la cellule mémoire est passante et un courant de lecture Iread supérieur à un seuil déterminé traverse la ligne de bit BLj. Le circuit de lecture RCTj fournit alors un bit bi,j dont la valeur est définie par convention, par exemple 1. Si le transistor FGT est dans l'état effacé, la cellule mémoire n'est pas passante ou est faiblement passante et le circuit de lecture RCTj fournit un bit bi,j de valeur inverse, ici un bit égal à 0.

La tension de lecture Vread a ainsi un rôle essentiel dans la détermination de la valeur du bit bi,j et doit être supérieure à la tension de seuil Vtp du transistor FGT dans l'état programmé et inférieure à la tension de seuil Vte du transistor FGT dans l'état effacé. Cela apparaît clairement sur la figure 3 qui représente une courbe CP de distribution statistique des tensions de seuil Vtp de cellules mémoire dans l'état programmé et une courbe CE de distribution statistique des tensions de seuil Vte de cellules mémoire dans l'état effacé, l'axe des ordonnées représentant un nombre statistique N de cellules mémoire. La courbe CP est comprise entre deux tensions de seuil négatives Vtp1, Vtp2, par exemple -1,5V et -3,5V, et la courbe CE est comprise entre deux tensions de seuils positives Vte1, Vte2, par exemple 1V et 3V. Entre les deux courbes de distribution CE, CP se trouve une courbe de distribution statistique CUV délimitée à gauche par la tension de seuil Vtp1 et à droite par la tension de seuil Vte1. Cette courbe CUV représente la distribution statistique des tensions de seuil de cellules mémoire ayant été effacées par un faisceau UV et se trouvant dans l'état UV. Ainsi, l'effacement UV a un effet différent de l'effacement électrique, puisque les cellules présentent des tensions de seuil qui ne correspondent ni à une tension de seuil d'un transistor à grille flottante programmé électriquement ni à une tension de seuil d'un transistor effacé électriquement.

La solution généralement retenue pour contrer un effacement UV frauduleux consiste à utiliser une tension de lecture Vread qui se situe à droite de la courbe de distribution statistique CUV, par exemple la tension Vte1 en figure 3 (les courbes CUV, CE étant ici contiguës). Ainsi, toute cellule mémoire ayant été effacée par UV et lue avec la tension Vread=Vte1 est dans l'état passant et est vue par le circuit de lecture comme une cellule mémoire programmée.

Toutefois, une tension de lecture aussi élevée rend les cellules mémoire fortement passantes (faible résistance série) pendant les phases de lecture, et entraîne un accroissement de la consommation d'énergie électrique. De plus, la tension de lecture doit se stabiliser et se propager à travers divers chemins conducteurs avant d'être appliquée à des cellules mémoire, ce qui impose un temps d'attente non négligeable après la mise sous tension du circuit intégré avant de pouvoir lire des données. Enfin, la tension de lecture étant décalée du côté des tensions de seuil des cellules mémoire effacées (courbe CE), toute dérive de la tension de seuil d'une cellule mémoire effacée au-delà de la tension de lecture se traduit par une erreur de lecture. Cette solution rend ainsi le processus de lecture sensible aux pertes de rétention dans les cellules mémoire effacées.

Une autre solution, décrite par EP 1 006 532, est de prévoir une cellule mémoire témoin qui est portée dans un état initial effacé ou programmé et est ensuite lue avec deux tensions de lecture, afin de détecter si la cellule mémoire se trouve bien dans l'état initial ou dans un état intermédiaire correspondant à l'état UV. Cette solution présente l'inconvénient de nécessiter deux tensions de lecture, l'une étant une tension de lecture "standard" et l'autre permettant de détecter si la cellule mémoire est dans l'état UV.

La présente invention est définie par les revendications 1 et 12.

Ainsi, la présente invention vise un procédé pour protéger une mémoire de données contre un effacement UV qui n'impose pas l'utilisation d'une tension de lecture supérieure à la tension de seuil de cellules mémoire dans l'état UV et qui n'impose pas l'utilisation de plusieurs tensions de lecture.

Cet objectif est atteint par la prévision d'un procédé pour protéger contre un effacement global de données un circuit intégré comprenant une mémoire de données programmable électriquement et une unité de contrôle pour exécuter des commandes de lecture ou d'écriture de la mémoire, comprenant les étapes consistant à prévoir dans le circuit intégré deux groupes de cellules mémoire témoin programmables électriquement comprenant chacun au moins une cellule mémoire témoin ; à la mise en service du circuit intégré, enregistrer dans les cellules mémoire témoin d'un premier groupe des bits ayant une première valeur et dans les cellules mémoire témoin d'un second groupe des bits ayant une seconde valeur inverse de la première valeur, les bits du premier et second groupe formant ensemble une combinaison de bits autorisée ; pendant le fonctionnement du circuit intégré suivant sa mise en service, lire et évaluer les cellules mémoire témoin, et bloquer le circuit intégré si les cellules mémoire témoin contiennent une combinaison de bits interdite différente de la combinaison autorisée.

Selon un mode de réalisation, une combinaison de bits est interdite si les cellules mémoire de chacun des groupes contiennent des bits de même valeur.

Selon un mode de réalisation, une combinaison de bits est interdite si toutes les cellules mémoire témoin du premier groupe contiennent des bits ayant la seconde valeur et/ou si toutes les cellules mémoire du second groupe contiennent des bits ayant la première valeur.

Selon un mode de réalisation, une combinaison de bits est interdite si au moins une cellule mémoire témoin du premier groupe contient au moins un bit ayant la seconde valeur et si au moins une cellule mémoire témoin du second groupe contient au moins un bit ayant la première valeur.

Selon un mode de réalisation, le blocage du circuit intégré comprend le blocage de l'unité de contrôle de manière que celle-ci n'exécute plus aucune commande.

Selon un mode de réalisation, on autorise l'exécution par le circuit intégré, après la mise en service du circuit intégré, d'une commande d'écriture des cellules mémoire témoin, pour permettre le blocage volontaire du circuit intégré.

Selon un mode de réalisation, la mémoire de données comprend un plan mémoire et dans lequel des cellules mémoires d'une zone du plan mémoire sont utilisées en tant que cellules mémoire témoin.

Selon un mode de réalisation, le procédé est appliqué à un circuit intégré dans lequel les cellules mémoire de la mémoire de données et les cellules mémoire témoin comprennent chacune un transistor à grille flottante, et dans lequel les cellules mémoires sont lues avec une tension de lecture de valeur nulle.

Selon un mode de réalisation, les cellules mémoire témoin sont lues et évaluées à chaque mise sous tension du circuit intégré suivant sa mise en service.

Selon un mode de réalisation, l'évaluation des cellules mémoire est faite au moyen d'un circuit à logique câblée implémentant une fonction logique d'évaluation.

La présente invention concerne également un circuit intégré comprenant une mémoire de données programmable électriquement et une unité de contrôle pour exécuter des commandes de lecture ou d'écriture de la mémoire, au moins deux groupes de cellules mémoire témoin programmables électriquement comprenant au moins une cellule mémoire témoin chacun, et des moyens pour bloquer le circuit intégré si les cellules mémoire des deux groupes contiennent des bits de même valeur.

Selon un mode de réalisation, le circuit intégré comprend deux cellules mémoire témoin, et des moyens pour bloquer le circuit intégré si les deux cellules mémoire témoin contiennent deux bits de même valeur.

Selon un mode de réalisation, le circuit intégré comprend au moins deux groupes de cellules mémoire témoin comprenant au moins deux cellules mémoire témoin chacun, et des moyens pour bloquer le circuit intégré si toutes les cellules mémoire témoin d'un même groupe contiennent des bits de même valeur et si cette valeur est différente d'une valeur attendue pour ce groupe de cellules mémoire témoin.

Selon un mode de réalisation, le circuit intégré comprend au moins deux groupes de cellules mémoire témoin comprenant au moins deux cellules mémoire témoin chacun, et des moyens pour bloquer le circuit intégré si une cellule mémoire témoin d'un premier groupe contient un bit dont la valeur est différente d'une valeur attendue pour les cellules mémoire témoin du premier groupe, et si une cellule mémoire témoin d'un second groupe contient un bit dont la valeur est différente d'une valeur attendue pour les cellules mémoire témoin du second groupe.

Selon un mode de réalisation, la valeur attendue pour les bits contenus dans les cellules mémoire du premier groupe est l'inverse de la valeur attendue pour les bits contenus dans les cellules mémoire du second groupe.

Selon un mode de réalisation, les moyens pour bloquer le circuit intégré comprennent des moyens de lecture et des moyens d'évaluation des cellules mémoire témoin, activés prioritairement à la mise sous tension du circuit intégré et fournissant un signal de blocage de l'unité de contrôle si les cellules mémoire témoin contiennent une combinaison de bits interdite.

Selon un mode de réalisation, le circuit intégré comprend des moyens d'évaluation des cellules mémoire témoin comprennent un circuit à logique câblée implémentant une fonction logique d'évaluation.

Selon un mode de réalisation, le circuit intégré comprend des moyens pour enregistrer une combinaison de bits autorisée dans les cellules mémoire témoin à la mise en service du circuit intégré, et des moyens pour empêcher ultérieurement l'écriture des cellules mémoire témoin.

Selon un mode de réalisation, l'unité de contrôle est configurée pour exécuter une commande d'écriture d'une combinaison de bits interdite dans les cellules mémoire témoin, afin de mettre hors service le circuit intégré.

Selon un mode de réalisation, des cellules mémoire de la mémoire de données et les cellules mémoire témoin comprennent chacune un transistor à grille flottante et sont lues en appliquant une tension de lecture de valeur nulle au transistor à grille flottante.

Selon un mode de réalisation, la mémoire de données comprend un plan mémoire et les cellules mémoires témoin sont agencées dans une zone dédiée du plan mémoire.

Ces objets, caractéristiques et avantages ainsi que d'autres de la présente invention seront exposés plus en détail dans la description suivante du procédé selon l'invention et d'un exemple de réalisation d'un circuit intégré selon l'invention, faite à titre non limitatif en relation avec les figures jointes parmi lesquelles :
- les figures 1A à 1D précédemment décrites illustrent l'utilisation d'une mémoire non volatile en tant que compteur d'unités,
- la figure 2 précédemment décrite représente un exemple de structure de cellule mémoire effaçable et programmable électriquement,
- la figure 3 précédemment décrite représente des courbes de distribution statistique de tensions de seuils de cellules mémoire se trouvant dans différents états,
- la figure 4 représente schématiquement un circuit intégré comprenant des moyens de mise en oeuvre du procédé de l'invention,
- la figure 5 est un organigramme décrivant des étapes du procédé de l'invention, et
- la figure 6 représente une variante de réalisation des moyens de mise en oeuvre du procédé de l'invention.

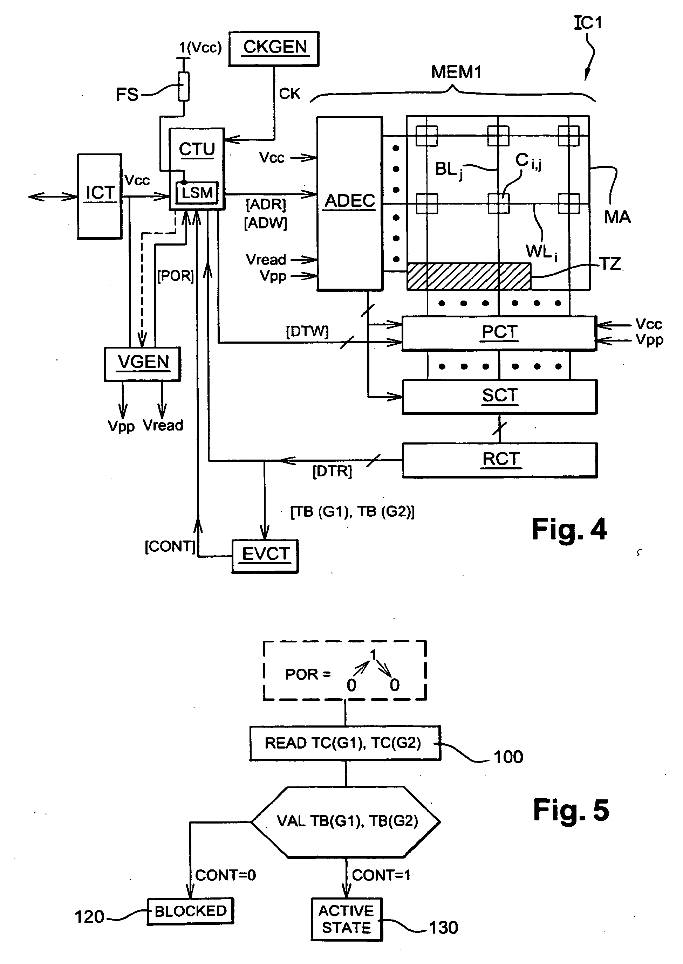

La figure 4 représente schématiquement l'architecture d'un circuit intégré IC1 comprenant des moyens de mise en oeuvre du procédé selon l'invention.

Le circuit intégré comprend un circuit d'interface de communication ICT, une unité de contrôle CTU, une mémoire MEM1 contenant des données de transaction, un générateur de tension VGEN et un circuit CKGEN fournissant un signal d'horloge CK à l'unité de contrôle CTU.

La mémoire MEM1 comprend un plan mémoire MA, un décodeur d'adresse ADEC, un circuit de programmation PCT, un circuit de sélection SCT et un circuit de lecture RCT. Le plan mémoire MA comprend des cellules mémoire Ci,j effaçables et programmables électriquement agencées selon des lignes horizontales et verticales et reliées à des lignes de mot WLi et à des lignes de bit BLj. La structure de chaque cellule mémoire est par exemple celle décrite plus haut en relation avec la figure 2.

Le circuit de programmation PCT comprend des verrous d'effacement-programmation (non représentés) reliés aux lignes de bit du plan mémoire, sélectionnés par le décodeur ADEC et recevant des données DTW à écrire dans le plan mémoire. Le circuit de lecture RDCT comprend un ou plusieurs amplificateurs de lecture reliés aux lignes de bits du plan mémoire MA par l'intermédiaire du circuit de sélection SCT et fournissant des données DTR lues dans le plan mémoire.

Le circuit ICT assure la liaison entre l'unité de contrôle CTU et l'extérieur du circuit intégré, pour la réception de commandes et l'envoi de réponses à des commandes, notamment des commandes de lecture ou d'écriture de la mémoire. Le circuit ICT peut être du type à contact et comprendre simplement une rangée de contacts électriques. Le circuit ICT peut également être du type sans contact ou "RFID" (Radio Frequency Identification). Dans ce cas, le circuit ICT comprend des circuits d'émission/réception de données radiofréquence (circuit d'antenne, circuit modulateur, circuit démodulateur...) qui sont conformes à des normes en vigueur telles que ISO/IEC 14443A/B, ISO/IEC 13693 ou conformes à des spécifications industrielles en cours de normalisation comme la spécification EPC™-GEN2 ("*Radio-Frequency Identity Protocols Class-1 Generation-2 - UHF RFID Protocol for Communications at 860 MHz - 960 MHz*").

Le circuit ICT fournit également une tension d'alimentation électrique Vcc au circuit intégré IC1. La tension Vcc est reçue via un contact électrique (mode de réalisation à contact) ou est extraite d'un signal de porteuse alternatif émis par un lecteur de circuit intégré sans contact (mode de réalisation sans contact ou RFID). Ainsi, la tension Vcc apparaît chaque fois que le circuit intégré est utilisé pour réaliser une transaction, après que le circuit intégré a été inséré dans un lecteur de carte à contact ou lorsqu'il se trouve en présence d'un champ magnétique ou électromagnétique émis par un lecteur sans contact.

Le générateur VGEN est contrôlé par l'unité CTU et fournit une tension de lecture Vread et une tension d'effacement-programmation Vpp. Le générateur VGEN fournit également de façon automatique un signal POR à la mise sous tension du circuit intégré, lorsque la tension Vcc apparaît. Le signal POR ou "Power On Reset" (signal de remise zéro à la mise sous tension) est appliqué à l'unité de contrôle CTU pour réinitialiser celle-ci. Le signal POR passe par exemple de 0 à 1 (valeur active) pendant une durée déterminée définissant une phase de réinitialisation du circuit intégré, puis repasse à 0. Ainsi, l'unité de contrôle CTU est ici remise à zéro à chaque mise sous tension du circuit intégré.

L'unité de contrôle CTU comprend une machine d'état à logique câblée LSM conçue pour exécuter les commandes reçues via le circuit ICT. Par exemple, sur réception d'une commande d'écriture de type "WRITE-ADW-DTW", l'unité CTU applique au décodeur ADEC une adresse de lecture ADW incluse dans la commande, applique au circuit de programmation PCT des données DTW à écrire dans le plan mémoire MA, également incluses dans la commande, applique la tension Vpp au circuit PCT et au décodeur ADEC, et déclenche un cycle d'effacement et de programmation de cellules mémoire. Sur réception d'une commande de lecture de type "READ-ADR", l'unité CTU applique au décodeur ADEC une adresse de lecture ADR incluse dans la commande, applique la tension Vread au décodeur ADEC, lit des données DTR en sortie du circuit RCT et envoie ces données dans une réponse à la commande, via le circuit ICT.

Selon l'invention, le circuit intégré IC1 comprend deux groupes G1, G2 de cellules mémoire témoin TC(G1), TC(G2) comprenant chacun au moins une cellule mémoire témoin. Ces cellules mémoire TC(G1), TC(G2) sont agencées ici dans une zone réservée TZ du plan mémoire MA et peuvent être lues par le circuit de lecture RCT. Un circuit d'évaluation EVCT, ici à logique câblée, est connecté à la sortie du circuit de lecture RCT afin de tester le contenu des cellules mémoire témoin. Le circuit EVCT fournit un signal CONT ("continuer") ayant une valeur par défaut égale par exemple à 0. Bien que représenté ici comme distinct de l'unité de contrôle CTU, ce circuit peut en pratique être intégré dans l'unité de contrôle.

Au moment de la mise en service du circuit intégré, les cellules mémoire témoin d'un groupe, par exemple les cellules TC(G1) du groupe G1, sont configurées dans l'état effacé, et les cellules mémoire témoin TC(G2) de l'autre groupe G2 sont configurées dans l'état programmé.

La machine d'état LSM de l'unité de contrôle CTU est configurée pour exécuter prioritairement une séquence de lecture et d'évaluation des cellules mémoire TC(G1), TC(G2) après avoir été remise à zéro par le signal POR, et se placer ensuite dans un état de blocage si le signal CONT ne présente pas une valeur d'évaluation positive, par exemple la valeur 1 si la valeur par défaut de ce signal est 0. Une telle séquence de lecture et d'évaluation des cellules mémoire témoin est prévue de façon inconditionnelle dans les cycles de changement d'états de la machine d'état LSM et ne peut être contournée, sauf au cours d'une phase de mise en service du circuit intégré où les cellules mémoire témoin sont configurées. Au terme de la phase de mise en service, une action est effectuée pour rendre incontournable la séquence de lecture et d'évaluation. Cette action est ici le claquage d'un fusible FS représenté sur la figure 4. Le fusible FS est initialement dans l'état passant et applique la valeur logique 1 (Vcc) à une entrée de la machine d'état LSM. Tant que le fusible n'est pas claqué, la machine d'état LSM n'exécute pas la séquence de lecture et d'évaluation. Lorsque le fusible est claqué, la séquence de lecture et d'évaluation est définitivement activée en tant que séquence prioritaire à effectuer après chaque remise à zéro.

La séquence de lecture et d'évaluation des cellules mémoire témoin est illustrée par un organigramme en figure 5 et comprend des étapes 100, 110, 120 et 130.

L'étape 100 ("READ TC(G1), TC(G2)") ou étape de lecture des cellules mémoire témoin de chaque groupe, est effectuée par l'unité de contrôle CTU après que le signal POR passe de 1 à 0 (fin de la période de remise à zéro). L'unité CTU applique au décodeur d'adresse ADEC l'adresse de la zone mémoire TZ et active le circuit de lecture RCT. Celui-ci fournit des bits témoin TB(G1), TB(G2) lus dans les cellules mémoire témoin de chaque groupe.

A l'étape 110 ("VAL TB(G1), TB(G2)"), le circuit d'évaluation EVCT détermine si les bits témoin TB(G1), TB(G2) forment ensemble une combinaison autorisée. Dans l'affirmative, le circuit EVCT met à 1 le signal CONT, sinon le circuit EVCT laisse le signal CONT à 0.

Si le signal CONT reste à 0, la machine d'état LSM de l'unité de contrôle CTU est aiguillée vers l'étape 120 ("BLOCKED") qui correspond à un état de blocage dans lequel elle n'exécute plus aucune opération, de sorte que le circuit intégré est entièrement bloqué jusqu'à une nouvelle remise sous tension.

Si le signal CONT passe à 1, l'unité de contrôle CTU est aiguillée vers l'étape 130 ("ACTIVE STATE") où elle se place dans un état actif. Cet état actif peut consister dans l'attente d'une commande, le circuit intégré étant prêt à exécuter une transaction, ou comprendre des opérations à réaliser avant d'exécuter la première commande (par exemple vérifier si le plan mémoire MA contient encore des unités non utilisées).

Selon l'invention, le test des cellules mémoire témoin TC(G1), TC(G2) par le circuit EVCT permet de déterminer si le circuit intégré a fait l'objet d'un effacement global aux UV (ou tout faisceau de particules ayant pour effet de placer les cellules mémoire dans l'état UV, Cf. courbe CUV en figure 3). En effet, les cellules mémoire témoin TC(G1) du groupe G1 ayant été configurées dans l'état effacé et les cellules mémoire témoin TC(G2) du groupe G2 configurées dans l'état programmé, les bits témoin TB(G1) du groupe G1 et les bits témoin TB(G2) du groupe G2 doivent en principe présenter des valeurs binaires inverses, par exemple "0" pour les bits TB(G1) et "1" pour les bits TB(G2). Dans le cas contraire, et notamment si ces bits sont égaux, un effacement UV est suspecté.

Le tableau 1 ci-après illustre la mise en oeuvre du procédé de l'invention lorsque deux cellules mémoire témoin TC1, TC2 sont prévues, la cellule TC1 ayant été effacée et la cellule TC2 programmée à la mise en service du circuit intégré. La combinaison attendue à la lecture des cellules mémoire témoin est ainsi "01" si "1" est la valeur logique d'une cellule mémoire programmée. Le signal CONT est laissé à 0 si les bits TB1, TB2 lus dans les cellules mémoire témoin TC1, TC2 sont identiques, c'est-à-dire s'ils sont tous deux égaux à 1 ou égaux à 0, ce qui est considéré ici comme signifiant que le circuit intégré a été exposé à un faisceau de particules ayant altéré leur état initial. La lecture de la combinaison "10" inverse de la combinaison attendue 01 est également considéré comme suspecte et le signal CONT est également laissé à 0 si cette combinaison est lue dans les cellules mémoire témoin.

Notons que le circuit EVCT est réalisable simplement sous forme de circuit à logique combinatoire implémentant une fonction logique d'évaluation "Fev" telle que : CONT = Fev(TB(G1),TB(G2).

**Tableau 1**

| | Groupe G1 | Groupe G2 | |
|---|---|---|---|
| Combinaison lue | TB1 | TB2 | CONT = Fev(TB1, TB2) |
| 0 | 0 | 0 | 0 |
| 1 (état initial) | 0 | 1 | 1 |
| 2 | 1 | 0 | 0 |
| 3 | 1 | 1 | 0 |

Le tableau 2 ci-après illustre la mise en oeuvre de l'invention lorsque quatre cellules mémoire témoin TC11 (groupe G1), TC12 (groupe G1), TC21 (groupe G2), TC22 (groupe G2) sont utilisées. A la mise en service du circuit intégré, les cellules TC11, TC12 sont effacées (écriture d'un 0) et les cellules TC21, TC22 sont programmées (écriture d'un 1). La combinaison attendue à la lecture des cellules mémoire, formée par des bits témoin TB11, TB12, TB21, TB22, est ainsi 0011 (soit 3h en notation hexadécimale).

Ce mode de réalisation à quatre cellules mémoire offre une grande souplesse dans la mise en oeuvre de l'invention car il permet de tolérer des pertes de charges électriques accidentelles ("retention loss") dans les grilles flottantes de cellules mémoire, altérant leur état initial, sans que cela ne provoque le blocage du circuit intégré.

A cet effet, plusieurs niveaux de tolérance sont envisageables :
- tolérance de niveau 0 (aucune tolérance) : le signal CONT est mis à 1 si et uniquement si la combinaison de bits lue dans les cellules mémoire témoin est égale à 0011 (état initial),
- tolérance de niveau 1 : le signal CONT est également mis à 1 si un bit et un seul parmi les bits témoin présente une valeur différente de la valeur attendue. Une évaluation avec tolérance de niveau 1 est représenté dans le tableau 2 : les combinaisons 1h, 2h, 7h, Bh (notation hexadécimale) sont considérées comme valables et le signal CONT est mis à 1.
- tolérance de niveau 2 : le signal CONT est également mis à 1 si un bit et un seul dans chaque groupe présente une valeur différente de la valeur attendue. Les combinaisons correspondantes sont repérées par le signe "*" dans le tableau 2 : les combinaisons 5h, 6h, 9h, Ah seraient considérées comme valables et le signal CONT serait mis à 1 si le niveau de tolérance 2 était retenu. La défaillance de deux cellules mémoire témoin sur quatre étant toutefois peu probable, une évaluation des cellules mémoire témoin avec le niveau 1 de tolérance est préférée.

En tout état de cause, quel que soit le niveau de tolérance aux pertes de charges électriques, le fait que toutes les cellules mémoire d'un même groupe G1 ou G2 présentent des bits ayant une valeur inverse de la valeur attendue (soit ici 0h, 4h, 8h, Ch, Dh, Eh, Fh) provoque le maintien du signal CONT à 0 et le blocage du circuit intégré.

**Tableau 2**

| Combinaison lue | Groupe G1 | | Groupe G2 | | |
|---|---|---|---|---|---|
| | TB11 | TB12 | TB21 | TB22 | CONT = Fev(TB11-TB22) |
| 0h | 0 | 0 | 0 | 0 | 0 |
| 1h | 0 | 0 | 0 | 1 | 1 |
| 2h | 0 | 0 | 1 | 0 | 1 |
| 3h (état initial) | 0 | 0 | 1 | 1 | 1 |
| 4h | 0 | 1 | 0 | 0 | 0 |
| 5h | 0 | 1 | 0 | 1 | 0 (*) |
| 6h | 0 | 1 | 1 | 0 | 0 (*) |
| 7h | 0 | 1 | 1 | 1 | 1 |
| 8h | 1 | 0 | 0 | 0 | 0 |
| 9h | 1 | 0 | 0 | 1 | 0 (*) |
| Ah | 1 | 0 | 1 | 0 | 0 (*) |
| Bh | 1 | 0 | 1 | 1 | 1 |
| Ch | 1 | 1 | 0 | 0 | 0 |
| Dh | 1 | 1 | 0 | 1 | 0 |
| Eh | 1 | 1 | 1 | 0 | 0 |
| Fh | 1 | 1 | 1 | 1 | 0 |

En relation avec le problème technique décrit au préambule, un avantage du procédé selon l'invention est de ne pas nécessiter une tension de lecture des cellules mémoire qui soit supérieure à la tension de seuil de cellules mémoire dans l'état UV. Notamment, la tension de lecture Vread peut avantageusement être égale à 0, de sorte que l'étape de lecture des cellules mémoire témoin (figure 5) ainsi que des étapes de lecture du plan mémoire MA peuvent être conduites rapidement sans attendre que la tension Vread ne se stabilise.

En référence à la figure 3, supposons qu'après un effacement UV la tension de seuil de cellules mémoire initialement programmées (soit les cellules mémoire témoin du groupe G2 et les cellules mémoire contenant des unités utilisées) reste inférieure à 0 malgré l'effacement UV. Dans ce cas, la séquence de lecture et d'évaluation des cellules mémoire témoin ne détectera pas l'effacement UV mais les cellules mémoire contenant des unités utilisées continueront à être vues dans l'état programmé. Par contre, si la tension de seuil des cellules mémoire initialement dans l'état programmé devient supérieure à 0 après l'effacement UV, toutes les données lues dans les cellules mémoire témoin sont égales à 0 et le circuit intégré se bloque au terme de la séquence de lecture et d'évaluation des cellules mémoire témoin.

Bien que le mode de réalisation préféré de l'invention comprenne l'utilisation d'une même tension de lecture pour lire chaque type de cellules mémoire, et de préférence une tension nulle, l'homme de l'art notera que l'invention peut néanmoins être mise en oeuvre avec des tensions différentes pour la lecture des cellules mémoire témoin et la lecture des cellules mémoire contenant des données. Par ailleurs, les cellules mémoire témoin pourraient être lues avec deux tensions de lecture pour trancher des cas ambigus tels la lecture des combinaisons 5h, 6h, 9h, Ah dans les quatre cellules mémoire témoin (tableau 2) ou la combinaison "10" dans les deux cellules mémoire témoin (tableau 1). Une telle lecture à deux niveaux de tension serait toutefois exceptionnelle et uniquement dans des situations ambiguës peu probables.

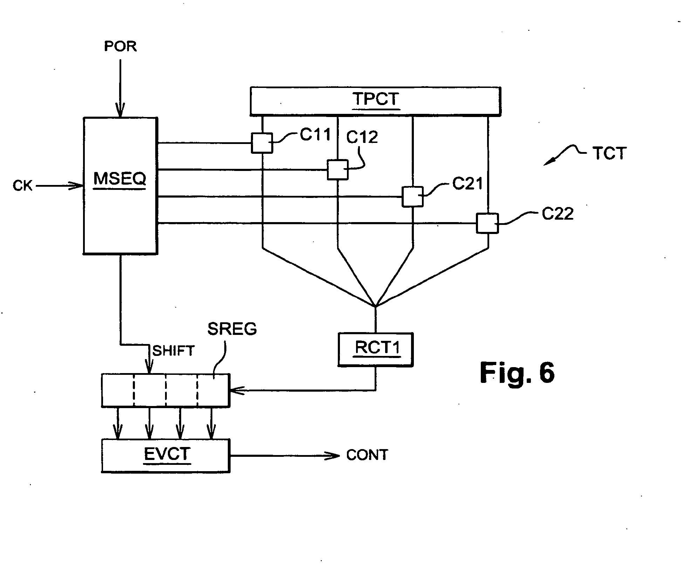

Par ailleurs, les cellules mémoire témoin ne sont pas nécessairement agencées dans le plan mémoire comme précédemment décrit. Pour fixer les idées, la figure 6 représente un circuit témoin TCT selon l'invention qui est autonome et distinct de l'unité de contrôle CTU et du plan mémoire MA. Le circuit TCT comprend par exemple :
- des cellules mémoire témoin indépendantes du plan mémoire MA, par exemple deux ou quatre cellules mémoire témoin, ici quatre cellules mémoire témoin C11, C12, C21, C22,
- un circuit TPCT de programmation des cellules mémoire témoin, à la mise en service du circuit intégré,
- un circuit de lecture RCT1 relié aux quatre cellules mémoire,
- un microséquenceur MSEQ à logique câblée, cadencé par le signal d'horloge CK, qui sélectionne les cellules mémoire en lecture les unes après les autres après que le signal POR passe de 1 à 0,
- un registre à décalage SREG recevant sur une entrée série les bits témoin lus dans les cellules mémoire témoin, et est piloté par un signal de décalage SHIFT fourni par le microséquenceur MSEQ, et
- le circuit d'évaluation EVCT décrit plus haut, ayant ici des entrées connectées aux sorties parallèles du registre SREG et une sortie fournissant le signal CONT.

Selon un mode de réalisation, l'unité de contrôle CTU est prévue pour exécuter une commande de mise hors service du circuit intégré. Une telle commande, en soi connue et désignée généralement commande "KILL", est prévue dans certaines applications afin de rendre le circuit intégré inutilisable après une transaction, par exemple après que les unités contenues dans la mémoire ont été entièrement utilisées ou après un passage en caisse d'un produit identifié par le circuit intégré (application de type étiquette électronique sans compteur d'unités, les données de transaction servant par exemple à identifier le produit et définir son prix). Notons que dans l'art antérieur, la commande KILL est généralement exécutée en modifiant la valeur d'un drapeau dans un registre de configuration du circuit intégré (registre d'état), ce qui verrouille l'unité de contrôle.

Ici, les moyens permettant de détecter un effacement UV des données de transaction sont utilisés pour mettre en oeuvre la commande KILL. Ainsi, sur réception de cette commande, l'unité de contrôle CTU accède aux cellules mémoire témoin présentes dans la zone mémoire témoin TZ (fig. 4) ou dans le circuit TCT (fig. 6) et y inscrit une donnée prédéfinie qui correspond à une combinaison interdite provoquant le maintien à 0 du signal CONT lors de la mise sous tension du circuit intégré. Cette combinaison interdite est de préférence l'inverse de la combinaison initiale. Par exemple, quand quatre cellules témoin sont utilisées, la combinaison interdite est "1100" (Cf. tableau 2).

Il apparaîtra clairement à l'homme de l'art que la présente invention est susceptible de diverses autres variantes de réalisation.

Notamment, l'unité de contrôle CTU peut être un microprocesseur qui exécute prioritairement un sous-programme de lecture et d'évaluation des cellules mémoire après chaque remise à zéro du microprocesseur. Ce sous-programme est de préférence protégé contre les violations en étant enregistré dans une mémoire non effaçable de type ROM. Le circuit témoin TCT représenté en figure 6 peut également être utilisé en combinaison avec un microprocesseur, pour éviter l'emploi d'un sous-programme. Avec une unité de contrôle à microprocesseur, le signal CONT à 0 peut être utilisé en tant que signal d'interruption prioritaire qui envoie le microprocesseur dans un sous-programme de blocage ou de remise zéro du microprocesseur ("Soft Reset").

Par ailleurs, on a proposé dans ce qui précède que les cellules mémoire témoin soient lues et évaluées à chaque mise sous tension du circuit intégré. Cela est en principe suffisant dans les applications où le circuit intégré est de type passif et est alimenté électriquement uniquement au moment où il est utilisé pour une transaction. Dans des applications où le circuit intégré est alimenté par une source de tension autonome (pile), la séquence de lecture et d'évaluation peut être réitérée de façon cyclique, par exemple avec des intervalles de temps réguliers définis par un compteur ou à chaque fois que le circuit intégré reçoit une commande exécutable, avant d'exécuter la commande.

La présente invention est également susceptible de diverses applications autres que la protection contre l'effacement de données de transaction ayant une valeur monétaire. L'invention est notamment applicable à la protection de données confidentielles, de mots de passe, de données d'identifications, etc.

L'invention est également applicable à divers types de mémoires non volatiles, notamment les mémoires Flash dont les cellules mémoire sont dépourvues de transistor d'accès.

## Revendications

1. Circuit intégré (IC1) comprenant une mémoire de données programmable électriquement (MEM1) et une unité de contrôle (CTU) pour exécuter des commandes de lecture ou d'écriture de la mémoire, **caractérisé en ce qu'**il comprend :
- au moins deux groupes (G1, G2) de cellules mémoire témoin programmables électriquement (TC(G1), TC(G2)) comprenant au moins une cellule mémoire témoin chacun (TC11, TC12, TC21, TC22), et
- des moyens (CTU, TCT, EVCT, CONT) pour bloquer le circuit intégré si les cellules mémoire des deux groupes contiennent des bits de même valeur.

2. Circuit intégré selon la revendication 1, comprenant :
- deux cellules mémoire témoin (TC1, TC2), et
- des moyens (CTU, TCT, EVCT, CONT) pour bloquer le circuit intégré si les deux cellules mémoire témoin contiennent deux bits (TB1, TB2) de même valeur.

3. Circuit intégré selon la revendication 1, comprenant :
- au moins deux groupes (G1, G2) de cellules mémoire témoin comprenant au moins deux cellules mémoire témoin chacun (TC11, TC12, TC21, TC22), et
- des moyens (CTU, TCT, EVCT, CONT) pour bloquer le circuit intégré si toutes les cellules mémoire témoin d'un même groupe contiennent des bits de même valeur et si cette valeur est différente d'une valeur attendue pour ce groupe de cellules mémoire témoin.

4. Circuit intégré selon l'une des revendications 1 et 3, comprenant :
- au moins deux groupes (G1, G2) de cellules mémoire témoin comprenant au moins deux cellules mémoire témoin chacun (TC11, TC12, TC21, TC22), et
- des moyens (CTU, TCT, EVCT, CONT) pour bloquer le circuit intégré si une cellule mémoire témoin d'un premier groupe contient un bit dont la valeur est différente d'une valeur attendue pour les cellules mémoire témoin du premier groupe, et si une cellule mémoire témoin d'un second groupe contient un bit dont la valeur est différente d'une valeur attendue pour les cellules mémoire témoin du second groupe.

5. Circuit intégré selon l'une des revendications 3 et 4, dans lequel la valeur attendue pour les bits contenus dans les cellules mémoire du premier groupe (G1) est l'inverse de la valeur attendue pour les bits contenus dans les cellules mémoire du second groupe (G2).

6. Circuit intégré selon l'une des revendications 1 à 5, dans lequel les moyens pour bloquer le circuit intégré comprennent des moyens de lecture (CTU, TCT) et des moyens d'évaluation (EVCT) des cellules mémoire témoin, activés prioritairement à la mise sous tension du circuit intégré et fournissant un signal de blocage. (CONT) de l'unité de contrôle (CTU) si les cellules mémoire témoin contiennent une combinaison de bits interdite.

7. Circuit intégré selon la revendication 6, dans lequel des moyens d'évaluation des cellules mémoire témoin comprennent un circuit à logique câblée (EVCT) implémentant une fonction logique d'évaluation (Fev).

8. Circuit intégré selon l'une des revendications 1 à 7, comprenant :
- des moyens (CTU, PCT, TPCT) pour enregistrer une combinaison de bits autorisée dans les cellules mémoire témoin à la mise en service du circuit intégré, et
- des moyens (FS, CTU) pour empêcher ultérieurement l'écriture des cellules mémoire témoin.

9. Circuit intégré selon l'une des revendications 1 à 7, dans lequel l'unité de contrôle (CTU) est configurée pour exécuter une commande (KILL) d'écriture d'une combinaison de bits interdite dans les cellules mémoire témoin, afin de mettre hors service le circuit intégré.

10. Circuit intégré selon l'une des revendications 1 à 9, dans lequel des cellules mémoire de la mémoire de données (MEM1) et les cellules mémoire témoin (TC(G1), TC(G2), TC1, TC2, TC11, TC12, TC21, TC22) comprennent chacune un transistor à grille flottante (FGT) et sont lues en appliquant une tension de lecture (Vread) de valeur nulle au transistor à grille flottante.

11. Circuit intégré selon l'une des revendications 1 à 10, dans lequel la mémoire de données (MEM1) comprend un plan mémoire (MA) et les cellules mémoires témoin sont agencées dans une zone dédiée (TZ) du plan mémoire.

12. Procédé pour protéger contre un effacement global de données un circuit intégré (IC1) comprenant une mémoire de données programmable électriquement (MEM1) et une unité de contrôle (CTU) pour exécuter des commandes de lecture ou d'écriture de la mémoire, **caractérisé en ce qu'**il comprend les étapes consistant à :
- prévoir dans le circuit intégré deux groupes (G1, G2) de cellules mémoire témoin programmables électriquement comprenant chacun au moins une cellule mémoire témoin (TC1, TC2, TC11, TC12, TC21, TC22),
- à la mise en service du circuit intégré, enregistrer dans les cellules mémoire témoin (TC1, TC11, TC12) d'un premier groupe (G1) des bits ayant une première valeur et dans les cellules mémoire témoin d'un second groupe (TC2, TC21, TC22) des bits ayant une seconde valeur inverse de la première valeur, les bits du premier et second groupe formant ensemble une combinaison de bits autorisée, et
- pendant le fonctionnement du circuit intégré suivant sa mise en service, lire et évaluer les cellules mémoire témoin, et bloquer le circuit intégré si les cellules mémoire témoin contiennent une combinaison de bits interdite différente de la combinaison autorisée.

13. Procédé selon la revendication 12, dans lequel une combinaison de bits est interdite si les cellules mémoire de chacun des groupes contiennent des bits de même valeur.

14. Procédé selon l'une des revendications 12 et 13, dans lequel une combinaison de bits est interdite si toutes les cellules mémoire témoin du premier groupe contiennent des bits ayant la seconde valeur et/ou si toutes les cellules mémoire du second groupe contiennent des bits ayant la première valeur.

15. Procédé selon l'une des revendications 12 à 14, dans lequel une combinaison de bits est interdite si au moins une cellule mémoire témoin du premier groupe contient au moins un bit ayant la seconde valeur et si au moins une cellule mémoire témoin du second groupe contient au moins un bit ayant la première valeur.

16. Procédé selon l'une des revendications 12 à 15, dans lequel le blocage du circuit intégré comprend le blocage de l'unité de contrôle (CTU) de manière que celle-ci n'exécute plus aucune commande.

17. Procédé selon l'une des revendications 12 à 16, dans lequel on autorise l'exécution par le circuit intégré, après la mise en service du circuit intégré, d'une commande (KILL) d'écriture des cellules mémoire témoin, pour permettre le blocage volontaire du circuit intégré.

18. Procédé selon l'une des revendications 12 à 17, dans lequel la mémoire de données (MEM1) comprend un plan mémoire (MA) et dans lequel des cellules mémoires d'une zone (TZ) du plan mémoire sont utilisées en tant que cellules mémoire témoin.

19. Procédé selon l'une des revendications 12 à 18, appliqué à un circuit intégré dans lequel les cellules mémoire de la mémoire de données (MEM1) et les cellules mémoire témoin (TC(G1), TC(G2), TC1, TC2, TC11, TC12, TC21, TC22) comprennent chacune un transistor à grille flottante (FGT), et dans lequel les cellules mémoires sont lues avec une tension de lecture (Vread) de valeur nulle.

20. Procédé selon l'une des revendications 12 à 19, dans lequel les cellules mémoire témoin sont lues et évaluées à chaque mise sous tension du circuit intégré suivant sa mise en service.

21. Procédé selon l'une des revendications 12 à 20, dans lequel l'évaluation des cellules mémoire est faite au moyen d'un circuit (EVCT) à logique câblée implémentant une fonction logique d'évaluation (Fev).

## Claims

1. An integrated circuit (IC1) comprising an electrically programmable data memory (MEM1) and a control unit (CTU) to execute commands for reading or writing the memory, **characterized in that** it comprises:
- at least two groups (G1, G2) of electrically programmable test memory cells (TC(G1), TC(G2)) each comprising at least one test memory cell (TC11, TC12, TC21, TC22), and
- means (CTU, TCT, EVCT, CONT) for blocking the integrated circuit if the memory cells of the two groups contain bits of the same value.

2. Integrated circuit according to claim 1, comprising:
- two test memory cells (TC1, TC2), and
- means (CTU, TCT, EVCT, CONT) for blocking the integrated circuit if the two test memory cells contain two bits (TB1, TB2) of the same value.

3. Integrated circuit according to claim 1, comprising:
- at least two groups (G1, G2) of test memory cells each comprising at least two test memory cells (TC11, TC12, TC21, TC22), and
- means (CTU, TCT, EVCT, CONT) for blocking the integrated circuit if all the test memory cells of a same group contain bits of the same value and if that value is different from a value expected for this group of test memory cells.

4. Integrated circuit according to one of claims 1 and 3, comprising:
- at least two groups (G1, G2) of test memory cells each comprising at least two test memory cells (TC11, TC12, TC21, TC22), and
- means (CTU, TCT, EVCT, CONT) for blocking the integrated circuit if a test memory cell of a first group contains a bit the value of which is different from a value expected for the test memory cells of the first group, and if a test memory cell of a second group contains a bit the value of which is different from a value expected for the test memory cells of the second group.

5. Integrated circuit according to one of claims 3 and 4, wherein the value expected for the bits contained in the memory cells of the first group (G1) is the opposite of the value expected for the bits contained in the memory cells of the second group (G2).

6. Integrated circuit according to one of claims 1 to 5, wherein the means for blocking the integrated circuit comprise read means (CTU, TCT) and evaluation means (EVCT) for reading and evaluating the test memory cells, activated in priority upon switching on the integrated circuit and supplying a blocking signal (CONT) for blocking the control unit (CTU) if the test memory cells contain a prohibited combination of bits.

7. Integrated circuit according to claim 6, wherein means for evaluating the test memory cells comprise a hard-wired logic circuit (EVCT) implementing a logic evaluation function (Fev).

8. Integrated circuit according to one of claims 1 to 7, comprising:
- means (CTU, PCT, TPCT) for recording an authorized combination of bits in the test memory cells upon the commissioning of the integrated circuit, and
- means (FS, CTU) for subsequently preventing the test memory cells from being written.

9. Integrated circuit according to one of claims 1 to 7, wherein the control unit (CTU) is configured for executing a command (KILL) for writing a prohibited combination of bits in the test memory cells, so as to put the integrated circuit out of order.

10. Integrated circuit according to one of claims 1 to 9, wherein memory cells of the data memory (MEM1) and the test memory cells (TC(G1), TC(G2), TC1, TC2, TC11, TC12, TC21, TC22) each comprise a floating-gate transistor (FGT) and are read by applying a zero-value read voltage (Vread) to the floating-gate transistor.

11. Integrated circuit according to one of claims 1 to 10, wherein the data memory (MEM1) comprises a memory array (MA) and the test memory cells are arranged in a dedicated zone (TZ) of the memory array.

12. A method for protecting against a global data erase an integrated circuit (IC1) comprising an electrically programmable data memory (MEM1) and a control unit (CTU) to execute commands for reading or writing the memory, **characterized in that** it comprises the steps of:
- providing in the integrated circuit two groups (G1, G2) of electrically programmable test memory cells each comprising at least one test memory cell (TC1, TC2, TC11, TC12, TC21, TC22) ,
- upon the commissioning of the integrated circuit, recording in the test memory cells (TC1, TC11, TC12) of a first group (G1) bits having a first value and in the test memory cells of a second group (TC2, TC21, TC22) bits having a second value that is the opposite of the first value, the bits of the first and second groups together forming an authorized combination of bits, and
- during the operation of the integrated circuit following its commissioning, reading and evaluating the test memory cells, and blocking the integrated circuit if the test memory cells contain a prohibited combination of bits different from the authorized combination.

13. Method according to claim 12, wherein a combination of bits is prohibited if the memory cells of each of the groups contain bits of the same value.

14. Method according to one of claims 12 and 13, wherein a combination of bits is prohibited if all the test memory cells of the first group contain bits having the second value and/or if all the memory cells of the second group contain bits having the first value.

15. Method according to one of claims 12 to 14, wherein a combination of bits is prohibited if at least one test memory cell of the first group contains at least one bit having the second value and if at least one test memory cell of the second group contains at least one bit having the first value.

16. Method according to one of claims 12 to 15, wherein the blocking of the integrated circuit comprises blocking the control unit (CTU) so that the latter no longer executes any command.

17. Method according to one of claims 12 to 16, wherein after the commissioning of the integrated circuit, the integrated circuit is authorized to execute a command (KILL) for writing the test memory cells to enable the voluntary blocking of the integrated circuit.

18. Method according to one of claims 12 to 17, wherein the data memory (MEM1) comprises a memory array (MA) and wherein memory cells of a zone (TZ) of the memory array are used as test memory cells.

19. Method according to one of claims 12 to 18, applied to an integrated circuit in which the memory cells of the data memory (MEM1) and the test memory cells (TC(G1), TC(G2), TC1, TC2, TC11, TC12, TC21, TC22) each comprise a floating-gate transistor (FGT), and in which the memory cells are read with a zero-value read voltage (Vread).

20. Method according to one of claims 12 to 19, wherein the test memory cells are read and evaluated every time the integrated circuit is switched on after being commissioned.

21. Method according to one of claims 12 to 20, wherein the memory cells are evaluated by means of a hard-wired logic circuit (EVCT) implementing a logic evaluation function (Fev).

## Patentansprüche

1. Integrierte Schaltung (IC1), einen elektrisch programmierbaren Datenspeicher (MEM1) umfassend und eine Steuereinheit (CTU), um Befehle zum Lesen oder Schreiben des Speichers auszuführen, **dadurch gekennzeichnet, dass** sie umfasst:
- mindestens zwei Gruppen (G1, G2) elektrisch programmierbarer Prüfspeicherzellen (TC(G1 ), TC(G2)), die jeweils mindestens eine Prüfspeicherzelle (TC11, TC12, TC21, TC22) umfassen, und
- Mittel (CTU, TCT, EVCT, CONT) zur Sperrung der integrierten Schaltung, wenn die Speicherzellen der beiden Gruppen Bits desselben Wertes enthalten.

2. Integrierte Schaltung nach Patentanspruch 1, umfassend:
- zwei Prüfspeicherzellen (TC1, TC2) und
- Mittel (CTU, TCT, EVCT, CONT) zur Sperrung der integrierten Schaltung, wenn die beiden Prüfspeicherzellen zwei Bits (TB1, TB2) desselben Wertes enthalten.

3. Integrierte Schaltung nach Patentanspruch 1, umfassend:
- mindestens zwei Gruppen (G1, G2) von Prüfspeicherzellen, die jeweils mindestens zwei Prüfspeicherzellen (TC11, TC12, TC21, TC22) umfassen, und
- Mittel (CTU, TCT, EVCT, CONT) zur Sperrung der integrierten Schaltung, wenn alle Prüfspeicherzellen einer und derselben Gruppe Bits desselben Wertes enthalten und wenn dieser Wert sich von einem bei dieser Gruppe von Prüfspeicherzellen erwarteten Wert unterscheidet.

4. Integrierte Schaltung nach einem der Patentansprüche 1 bis 3, umfassend:
- mindestens zwei Gruppen (G1, G2) von Prüfspeicherzellen, die jeweils mindestens zwei Prüfspeicherzellen (TC11, TC12, TC21, TC22) umfassen, und
- Mittel (CTU, TCT, EVCT, CONT) zur Sperrung der integrierten Schaltung, wenn eine Prüfspeicherzelle einer ersten Gruppe ein Bit enthält, dessen Wert sich von einem bei den Prüfspeicherzellen der ersten Gruppe erwarteten Wert unterscheidet, und wenn eine Prüfspeicherzelle einer zweiten Gruppe ein Bit enthält, dessen Wert sich von einem bei den Prüfspeicherzellen der zweiten Gruppe erwarteten Wert unterscheidet.

5. Integrierte Schaltung nach einem der Patentansprüche 3 und 4, in der der für die Bits, die in den Speicherzellen der ersten Gruppe (G1) enthalten sind, erwartete Wert der dem für die Bits, die in den Speicherzellen der zweiten Gruppe (G2) enthalten sind, erwarteten Wert entgegengesetzte ist.

6. Integrierte Schaltung nach einem der Patentansprüche 1 bis 5, in der die Mittel zur Sperrung der integrierten Schaltung Mittel zum Lesen (CTU, TCT) und Mittel zum Bewerten (EVCT) der Prüfspeicherzellen umfassen, Tätigkeiten, die vorrangig beim Unterspannungsetzen der integrierten Schaltung stattfinden und ein Signal (CONT) zur Sperrung der Steuereinheit (CTU) liefern, wenn die Prüfspeicherzellen eine unzulässige Bit-Kombination enthalten.

7. Integrierte Schaltung nach Patentanspruch 6, in der die Mittel zum Bewerten der Prüfspeicherzellen eine Schaltung mit festverdrahteter Logik (EVCT) umfassen, die eine logische Bewertungsfunktion (Fev) implementiert.

8. Integrierte Schaltung nach einem der Patentansprüche 1 bis 7, umfassend:
- Mittel (CTU, PCT, TPCT) zur Speicherung einer zulässigen Bitkombination in den Prüfspeicherzellen bei Inbetriebnahme der integrierten Schaltung, und
- Mittel (FS, CTU) zur Verhinderung eines späteren Schreibens der Prüfspeicherzellen.

9. Integrierte Schaltung nach einem der Patentansprüche 1 bis 7, in der die Steuereinheit (CTU) derart konfiguriert ist, dass sie einen Befehl (KILL) zum Schreiben einer unzulässigen Bitkombination in die Prüfspeicherzellen ausführt, um die integrierte Schaltung außer Betrieb zu setzen.

10. Integrierte Schaltung nach einem der Patentansprüche 1 bis 9, in der die Speicherzellen des Datenspeichers (MEM1) und die Prüfspeicherzellen (TC(G1), TC(G2), TC1, TC2, TC11, TC12, TC21, TC22) jeweils einen Floating Gate Transistor (FGT) umfassen und gelesen werden, indem eine Lesespannung (Vread) des Betrages Null an den Floating Gate Transistor angelegt wird.

11. Integrierte Schaltung nach einem der Patentansprüche 1 bis 10, in der der Datenspeicher (MEM1) eine Speicherebene (MA) umfasst und die Prüfspeicherzellen in einem zugewiesenen Bereich (TZ) der Speicherebene angeordnet sind.

12. Verfahren zum Schutz einer integrierten Schaltung (IC1) vor umfangreichem Löschen der Daten, die einen elektrisch programmierbaren Datenspeicher (MEM1) umfasst und eine Steuereinheit (CTU), um Befehle zum Lesen oder Schreiben des Speichers auszuführen, **dadurch gekennzeichnet, dass** er die Schritte umfasst, darin bestehend:
- zwei Gruppen (G1, G2) elektrisch programmierbarer Prüfspeicherzellen in der integrierten Schaltung vorzusehen, die jeweils mindestens eine Prüfspeicherzelle (TC1, TC2, TC11, TC12, TC21, TC22) umfassen,
- bei der Inbetriebnahme der integrierten Schaltung in den Prüfspeicherzellen (TC1, TC11, TC12) einer ersten Gruppe (G1) Bits zu speichern, die einen ersten Wert haben, und in den Prüfspeicherzellen einer zweiten Gruppe (TC2, TC21, TC22) Bits, die einen zweiten Wert haben, der zum ersten Wert entgegengesetzt ist, wobei die Bits der ersten und der zweiten Gruppe zusammen eine zulässige Bitkombination bilden, und
- während der Arbeit der integrierten Schaltung nach deren Inbetriebnahme die Prüfspeicherzellen zu lesen und zu bewerten und die integrierte Schaltung zu sperren, wenn die Prüfspeicherzellen eine unzulässige Bitkombination enthalten, die sich von der zulässigen Kombination unterscheidet.

13. Verfahren nach Patentanspruch 12, in dem eine Bitkombination unzulässig ist, wenn die Speicherzellen jeder der Gruppen Bits desselben Wertes enthalten.

14. Verfahren nach einem der Patentansprüche 12 und 13, in dem eine Bitkombination unzulässig ist, wenn alle Prüfspeicherzellen der ersten Gruppe Bits enthalten, die den zweiten Wert aufweisen und/oder wenn alle Speicherzellen der zweiten Gruppe Bits enthalten, die den ersten Wert haben.

15. Verfahren nach einem der Patentansprüche 12 bis 14, in dem eine Bitkombination unzulässig ist, wenn mindestens eine Prüfspeicherzelle der ersten Gruppe mindestens ein Bit enthält, das den zweiten Wert aufweist und wenn mindestens eine Prüfspeicherzelle der zweiten Gruppe mindestens ein Bit enthält, das den ersten Wert hat.

16. Verfahren nach einem der Patentansprüche 12 bis 15, in dem die Sperrung der integrierten Schaltung die Sperrung der Steuereinheit (CTU) umfasst, derart, dass diese keinerlei Befehl mehr ausführt.

17. Verfahren nach einem der Patentansprüche 12 bis 16, in dem nach der Inbetriebnahme der integrierten Schaltung die Ausführung eines Befehls (KILL) durch die integrierte Schaltung zum Schreiben der Prüfspeicherzellen zugelassen wird, um die gewollte Sperrung der integrierten Schaltung zu ermöglichen.

18. Verfahren nach einem der Patentansprüche 12 bis 17, in dem der Datenspeicher (MEM1) eine Speicherebene (MA) umfasst und in dem Speicherzellen eines Bereiches (TZ) der Speicherebene als Prüfspeicherzellen verwendet werden.

19. Verfahren nach einem der Patentansprüche 12 bis 18, angewandt auf eine integrierte Schaltung, in der die Speicherzellen des Datenspeichers (MEM1) und die Prüfspeicherzellen (TC(G1), TC(G2), TC1, TC2, TC11, TC12, TC21, TC22) jeweils einen Floating Gate Transistor (FGT) umfassen und in dem die Speicherzellen mit einer Lesespannung (Vread) des Betrages Null gelesen werden.

20. Verfahren nach einem der Patentansprüche 12 bis 19, in dem die Prüfspeicherzellen bei jedem Unterspannungsetzen der integrierten Schaltung nach ihrer Inbetriebnahme gelesen und bewertet werden.

21. Verfahren nach einem der Patentansprüche 12 bis 20, in dem die Bewertung der Speicherzellen mit Hilfe einer Schaltung (EVCT) mit festverdrahteter Logik erfolgt, die eine logische Bewertungsfunktion (Fev) implementiert.
